# EUROPEAN PATENT APPLICATION

(11) **EP 4 832 347 A1**
(43) Date of publication of application: **28.10.2026**
(21) Application number: 24921404.0
(22) Date of filing: 02.09.2024
(51) Int. Cl.: H03H 9/25

(54) **SURFACE ACOUSTIC WAVE RESONATOR, FILTER, RADIO FREQUENCY FRONT-END MODULE AND ELECTRONIC DEVICE**

(30) Priority: 01.02.2024 CN 202410146507
(71) Applicant: Huawei Technologies Co., Ltd., Shenzhen, Guangdong 518129 (CN)
(72) Inventor: LUAN, Zhongzhi, Shenzhen, Guangdong 518129 (CN); TANG, Daiping, Shenzhen, Guangdong 518129 (CN); LI, Yan, Shenzhen, Guangdong 518129 (CN)
(74) Representative: Huawei European IPR
(86) International application number: PCT/CN2024/116409
(87) International publication number: WO 2025/161379

(57) **Abstract**

Embodiments of this application relate to the field of radio frequency technologies, and provide a surface acoustic wave resonator, a filter, a radio frequency front-end module, and an electronic device, to improve suppression on a spurious mode in a SAW filter. The surface acoustic wave resonator includes a substrate, and a low acoustic velocity layer, a first high acoustic velocity layer, a piezoelectric layer, and interdigital electrodes that are disposed on a same side of the substrate. A material of the piezoelectric layer includes a LiNbO₃ single crystal. The first high acoustic velocity layer is disposed on a side of the low acoustic velocity layer away from the substrate, the piezoelectric layer is disposed on a side of the first high acoustic velocity layer away from the substrate, and the interdigital electrodes are disposed on a side of the piezoelectric layer away from the substrate. The first high acoustic velocity layer is disposed between the low acoustic velocity layer and the piezoelectric layer, so that intensity of a Rayleigh mode on a low-frequency side of a main mode in the surface acoustic wave resonator can be effectively suppressed.

## Description

This application claims priority to Chinese Patent Application No. 202410146507.1, filed with the China National Intellectual Property Administration on February 1, 2024 and entitled "SURFACE ACOUSTIC WAVE RESONATOR, FILTER, RADIO FREQUENCY FRONT-END MODULE, AND ELECTRONIC DEVICE", which is incorporated herein by reference in its entirety.

### TECHNICAL FIELD

This application relates to the field of radio frequency technologies, and in particular, to a surface acoustic wave resonator, a filter, a radio frequency front-end module, and an electronic device.

### BACKGROUND

With the explosive growth of mobile data, the communication industry is evolving toward a 5th generation mobile communication technology (5th generation mobile communication technology, 5G). This requires radio frequency front-end filters to have a higher frequency, a larger bandwidth, and higher power tolerance. Currently, radio frequency front-end filters are mainly classified into surface acoustic wave (surface acoustic wave, SAW) filters and bulk acoustic wave (bulk acoustic wave, BAW) filters. The SAW filter plays an important role in suppressing high-order harmonic waves, image information, transmit leakage signals, and various parasitic interference of electronic devices.

In the context of the 4th generation mobile communication technology (the 4th generation mobile communication technology, 4G) and the 5th generation mobile communication technology (the 5th generation mobile communication technology, 5G) using carrier frequencies of higher frequency bands to implement high-bandwidth and low-latency communication, the industry urgently requires surface acoustic wave filters with a higher frequency, a higher quality factor, and low or no spurious modes.

### SUMMARY

Embodiments of this application provide a surface acoustic wave resonator, a filter, a radio frequency front-end module, and an electronic device, to improve suppression on a spurious mode in a SAW filter.

To achieve the foregoing objective, this application uses the following technical solutions.

According to a first aspect of embodiments of this application, a surface acoustic wave resonator is provided, including: a substrate, and a low acoustic velocity layer, a first high acoustic velocity layer, a piezoelectric layer, and interdigital electrodes (interdigital electrodes, IDEs) that are disposed on a same side of the substrate. A material of the piezoelectric layer includes a lithium niobate (LiNbO₃, LN) single crystal. The low acoustic velocity layer is disposed on a side of the substrate, the first high acoustic velocity layer is disposed on a side of the low acoustic velocity layer away from the substrate, the piezoelectric layer is disposed on a side of the first high acoustic velocity layer away from the substrate, and the interdigital electrodes are disposed on a one side of the piezoelectric layer away from the substrate. A shear horizontal surface acoustic wave velocity of the material of the piezoelectric layer is greater than a shear horizontal bulk acoustic wave velocity of a material of the low acoustic velocity layer, and the shear horizontal surface acoustic wave velocity of the material of the piezoelectric layer is less than a shear horizontal bulk acoustic wave velocity of a material of the first high acoustic velocity layer. The shear horizontal bulk acoustic wave velocity is a propagation velocity, in an arrangement direction of the interdigital electrodes, of a surface wave whose vibration direction is in a shear direction. The shear horizontal bulk acoustic wave velocity is a propagation velocity, in an arrangement direction of the interdigital electrodes, of a bulk acoustic wave whose vibration direction is in a shear direction. The shear direction is perpendicular to a thickness direction of the surface acoustic wave resonator and the arrangement direction of the interdigital electrodes.

When the material of the piezoelectric layer in the surface acoustic wave resonator includes a LiNbO₃ single crystal, spurious modes such as a Rayleigh mode usually exist on the low-frequency side of the main mode. The first high acoustic velocity layer is disposed between the low acoustic velocity layer and the piezoelectric layer. Because a distribution depth of the Rayleigh mode in the thickness direction of the surface acoustic wave resonator is greater than a distribution depth of the main mode in the thickness direction, the first high acoustic velocity layer has a better acoustic velocity improvement effect on the Rayleigh mode than the main mode. In this way, a frequency spacing between the Rayleigh mode and the main mode can be reduced, so that the Rayleigh mode and the main mode are coupled, to achieve an effect of effectively suppressing intensity of the Rayleigh mode on the low-frequency side of the main mode in the surface acoustic wave resonator.

In a possible implementation, a thickness *h*₁ of the first high acoustic velocity layer ranges from 0.1λ to λ, and λ is a wavelength of a surface acoustic wave. Limiting the thickness of the first high acoustic velocity layer to 0.1λ to λ can better suppress the spurious mode (Rayleigh mode) on the low-frequency side of the main mode. If the thickness of the first high acoustic velocity layer is excessively small, the suppression on the Rayleigh mode may not be ideal even after the low acoustic velocity layer and the first high acoustic velocity layer are stacked.

In a possible implementation, the thickness *h*₁ of the first high acoustic velocity layer satisfies: $\left(1.38∗{10}^{- 4}∗V-0.318\right) ∗ \frac{{h}_{1}}{λ} - 1.7765 ∗ \frac{{h}_{2}}{λ} + 5.3 ∗ {10}^{- 2} ∗ \frac{{h}_{3}}{λ} + 6.83 ∗ {10}^{- 2} ∗ \frac{{h}_{4}}{λ} - 3.366 ∗ {10}^{- 7} ∗ {λ}^{2} + 1.178 ∗ λ + 0.2965 > 1 ,$ where *V* is the shear horizontal bulk acoustic wave velocity of the material of the first high acoustic velocity layer, *h*₂ is a thickness of the interdigital electrode, *h*₃ is a thickness of the piezoelectric layer, and *h*₄ is a thickness of the low acoustic velocity layer. In this way, the spurious mode (Rayleigh mode) on the low-frequency side of the main mode is almost completely suppressed, and performance of the surface acoustic wave filter is good.

In a possible implementation, the surface acoustic wave resonator further includes a second high acoustic velocity layer, the second high acoustic velocity layer is disposed on a side of the low acoustic velocity layer close to the substrate, and a shear horizontal bulk acoustic wave velocity of a material of the second high acoustic velocity layer is greater than the shear horizontal bulk acoustic wave velocity of the material of the low acoustic velocity layer. The second high acoustic velocity layer is disposed on the side of the low acoustic velocity layer close to the substrate, so that an acoustic wave can be prevented from leaking to the side of the second high acoustic velocity layer close to the substrate. The wave is confined in space in which the piezoelectric layer and the low acoustic velocity layer are stacked, and is reused, so that a loss of a Q value is reduced.

In a possible implementation, the material of the first high acoustic velocity layer includes at least one of silicon nitride, polycrystalline silicon, silicon carbide, and silicon oxynitride. The material selection is technically mature.

In a possible implementation, the thickness *h*₄ of the low acoustic velocity layer ranges from 0.1λ to λ, and λ is the wavelength of the surface acoustic wave. Limiting the thickness of the low acoustic velocity layer to 0.1λ to λ can better suppress the spurious mode (Rayleigh mode) on the low-frequency side of the main mode. If the thickness of the low acoustic velocity layer is excessively small, the suppression on the Rayleigh mode may not be ideal even after the low acoustic velocity layer and the first high acoustic velocity layer are stacked.

In a possible implementation, the thickness *h*₃ of the piezoelectric layer ranges from 0.1λ to 0.5λ, and λ is the wavelength of the surface acoustic wave. Limiting the thickness of the piezoelectric layer to 0.1λ to 0.5λ can better suppress the spurious mode (Rayleigh mode) on the low-frequency side of the main mode.

In a possible implementation, the thickness *h*₂ of the interdigital electrode ranges from 0.05λ to 0.1λ, and λ is the wavelength of the surface acoustic wave. Limiting the thickness of the interdigital electrode to 0.05λ to 0.1λ can better suppress the spurious mode (Rayleigh mode) on the low-frequency side of the main mode.

In a possible implementation, a thickness *h*₅ of the second high acoustic velocity layer ranges from 0.1λ to λ, and λ is the wavelength of the surface acoustic wave. Limiting the thickness of the second high acoustic velocity layer to 0.1λ to λ can better suppress the spurious mode (Rayleigh mode) on the low-frequency side of the main mode.

According to a second aspect of embodiments of this application, a filter is provided, including a plurality of surface acoustic wave resonators that are cascaded, where the surface acoustic wave resonator is the surface acoustic wave resonator according to any one of the possible implementations of the first aspect.

The filter provided in the second aspect of embodiments of this application includes the surface acoustic wave resonator in the first aspect. A beneficial effect of the filter is the same as a beneficial effect of the surface acoustic wave resonator. Details are not described herein again.

According to a third aspect of embodiments of this application, a radio frequency front-end module is provided. The radio frequency front-end module includes a filter and an amplifier, the filter is coupled to the amplifier, and the filter is the filter according to the second aspect.

The radio frequency front-end module provided in the third aspect of embodiments of this application includes the filter according to the second aspect. A beneficial effect of the radio frequency front-end module is the same as a beneficial effect of the filter. Details are not described herein again.

According to a fourth aspect of embodiments of this application, an electronic device is provided. The electronic device includes a filter and a circuit board, the filter is disposed on the circuit board, and the filter is the filter according to the second aspect.

The electronic device provided in the fourth aspect of embodiments of this application includes the filter according to the second aspect. A beneficial effect of the electronic device is the same as a beneficial effect of the filter. Details are not described herein again.

### BRIEF DESCRIPTION OF DRAWINGS

FIG. 1 is a diagram of a structure of an electronic device according to an embodiment of this application;
FIG. 2 is a diagram of a structure of an RF front-end module according to an embodiment of this application;
FIG. 3 is a schematic of a topology of a filter according to an embodiment of this application;
FIG. 4 is a diagram of a structure of a surface acoustic wave resonator according to an embodiment of this application;
FIG. 5 is a diagram of an admittance curve of a surface acoustic wave resonator according to an embodiment of this application;
FIG. 6 is a diagram of a structure of a surface acoustic wave resonator according to an embodiment of this application;
FIG. 7 is a diagram of an admittance curve of a surface acoustic wave resonator according to an embodiment of this application;
FIG. 8 is a diagram of an admittance curve of a surface acoustic wave resonator according to an embodiment of this application;
FIG. 9 is a diagram of a structure of a surface acoustic wave resonator according to an embodiment of this application; and
FIG. 10 is a top view of an interdigital electrode according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "second" and "first" below are only for ease of description, and cannot be understood as indicating or implying relative importance or implicitly indicating a quantity of indicated technical features. Therefore, a feature limited by "second", "first", or the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these directional terms may be relative concepts. They are used for description and clarification of relative positions, and may vary accordingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact or indirect contact through an intermediate medium.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. The character "/" generally indicates an "or" relationship between the associated objects.

The technical solutions of this application may be applied to various electronic devices including power amplifiers. The electronic device may be deployed on land, including an indoor or outdoor electronic device, and a handheld or vehicle-mounted electronic device; may be deployed on water (for example, on a ship); or may be deployed in the air (for example, on an airplane, a balloon, or a satellite). For example, the channel device may be a terminal or a base station. For example, the terminal includes but is not limited to a mobile phone (mobile phone), a tablet computer, a notebook computer, a palmtop computer, a mobile internet device (mobile internet device, MID), a wearable device (for example, a smartwatch, a smart band, or a pedometer), a vehicle-mounted device (for example, an automobile, a bicycle, an electric vehicle, an airplane, a ship, a train, or a high-speed train), a virtual reality (virtual reality, VR) device, an augmented reality (augmented reality, AR) device, a wireless terminal in industrial control (industrial control), a smart home device (for example, a refrigerator, a television, an air conditioner, or an electricity meter), an intelligent robot, a workshop device, a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a flight device (for example, an intelligent robot, a hot air balloon, an uncrewed aerial vehicle, or an airplane), a radio frequency front-end module, or the like.

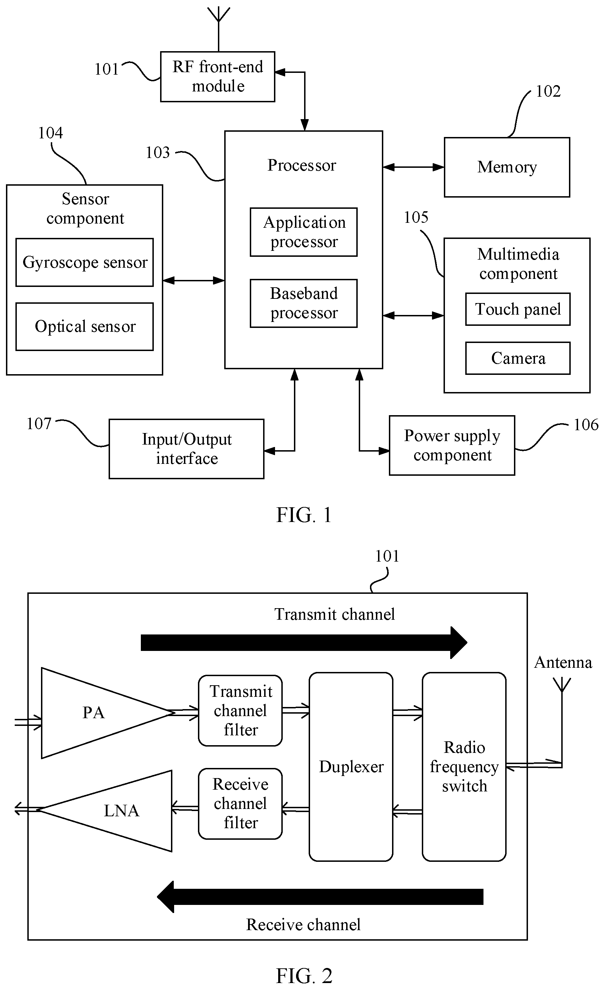

FIG. 1 is a diagram of a structure of an electronic device according to an embodiment of this application. The electronic device is described by using a mobile phone as an example. The electronic device includes a radio frequency (radio frequency, RF) front-end module 101, a memory 102, a processor 103, a sensor component 104, a multimedia component 105, a power supply component 106, and an input/output interface 107.

The following specifically describes the components of the mobile phone with reference to FIG. 1.

The RF front-end module 101 may be configured to: receive and send signals in an information receiving or sending process or a call process. Particularly, after receiving downlink information of the electronic device, the RF front-end module 101 sends the downlink information to the processor 103 for processing, and sends uplink data to the electronic device.

The memory 102 may be configured to store data, a software program, and a module. The mobile phone may include a high-velocity random access memory, and may further include a non-volatile memory, for example, at least one magnetic disk storage device, a flash memory device, or another volatile solid-state storage device.

The processor 103 is a control center of the mobile phone, connects all parts of the entire mobile phone through various interfaces and lines, and performs various functions of the mobile phone and data processing by running or executing the software program and/or module stored in the memory 102 and invoking data stored in the memory 102, to perform overall control on the mobile phone.

The sensor component 104 includes one or more sensors, and is configured to provide status evaluation in various aspects for the mobile phone. The sensor component 104 may include an acceleration sensor, a gyroscope sensor, a magnetic sensor, a pressure sensor, a temperature sensor, or the like. The sensor component 104 may detect acceleration/deceleration, an orientation, an on/off state, relative positioning of a component, a temperature change of the mobile phone, or the like. In addition, the sensor component 104 may further include an optical sensor, for example, a CMOS or CCD image sensor, and is used in an imaging application.

The multimedia component 105 provides a screen that serves as an output interface between the mobile phone and a user. The screen may be a touch panel. When the screen is a touch panel, the screen may be implemented as a touchscreen to receive an input signal from the user. In addition, the multimedia component 105 further includes at least one camera. For example, the multimedia component 105 includes a front-facing camera and/or a rear-facing camera.

The power supply component 106 is configured to supply power to each component of the mobile phone. The power supply component 106 may include a power management system, one or more power supplies, and another component associated with power generation, power management, and power distribution of the mobile phone.

The input/output interface 107 provides an interface between the processor 103 and a peripheral interface module. For example, the peripheral interface module may be a keyboard, a mouse, or the like.

Although not shown, the mobile phone may further include an audio component, a communication module, and the like. For example, the audio component includes a microphone, a speaker, and the like. The communication module may include one or more of a wireless fidelity (wireless fidelity, Wi-Fi) module, a Bluetooth module, a near field communication (near field communication, NFC) module, a global navigation satellite system (global navigation satellite system, GNSS) module, or a frequency modulation (frequency modulation, FM) module. Details are not described in embodiments of this application. A person skilled in the art can understand that the mobile phone structure shown in FIG. 1 does not constitute any limitation on the mobile phone, and the mobile phone may include more or fewer components than those shown in the figure, or combine a part of the components, or have different layouts of the components.

FIG. 2 is a diagram of a structure of an RF front-end module according to an embodiment of this application.

Generally, the RF front-end module 101 includes but is not limited to a radio frequency switch, a duplexer, a filter, a power amplifier circuit (power amplifier, PA), a low noise amplifier circuit (low noise amplifier, LNA), and the like. For example, as shown in FIG. 2, the RF front-end module 101 may include a radio frequency switch, a duplexer, a filter, a PA, and an LNA.

The RF front-end module 101 may include a transmit channel and a receive channel. The transmit channel includes a PA and a transmit channel filter. A radio frequency output end of the PA is coupled to an input end of the transmit channel filter. The receive channel includes an LNA and a receive channel filter. An output end of the receive channel filter is coupled to a radio frequency input end of the LNA.

The duplexer is responsible for performing duplex switching in a frequency division duplex system and filtering a radio frequency signal of the receive channel/transmit channel, and the radio frequency switch is responsible for switching between the receive channel and the transmit channel.

A baseband signal is transmitted to the transmit channel through a transceiver. The transmit channel amplifies a received radio frequency signal, outputs the radio frequency signal to an antenna, and transmits the radio frequency signal through the antenna. The PA is responsible for amplifying the radio frequency signal of the transmit channel, and the transmit channel filter is responsible for filtering the radio frequency signal of the transmit channel.

It should be noted that, when the electronic device includes a plurality of antennas, one antenna may correspond to one PA, or one antenna may correspond to a plurality of PAs, or a plurality of antennas may share one PA. All application scenarios in the related technologies are applicable to embodiments of this application.

The receive channel receives the radio frequency signal from the antenna. The radio frequency signal is amplified through the receive channel and then output, and is transmitted to a baseband through the transceiver. The LNA is responsible for amplifying the radio frequency signal of the receive channel, and the receive channel filter is responsible for filtering the radio frequency signal of the receive channel.

In the context of the 4th generation mobile communication technology (the 4th generation mobile communication technology, 4G) and the 5th generation mobile communication technology (the 5th generation mobile communication technology, 5G) using carrier frequencies of higher frequency bands to implement high-bandwidth and low-latency communication, a surface acoustic wave filter with a higher frequency, a higher quality factor, and low or no spurious modes is urgently needed in the industry. In a carrier aggregation technology, signal paths of different frequency bands need to work at the same time, and this feature requires that the used filter has very good band-stop suppression performance.

An embodiment of this application provides a filter. The filter may be used in the foregoing electronic device 1, for example, used in the radio frequency front-end module 101 in the electronic device 1. The filter is coupled to an amplifier to perform signal processing and transmission. Alternatively, the filter is directly disposed on a circuit board of the electronic device 1. A form of the filter in the electronic device 1 is not limited in embodiments of this application.

The filter provided in this embodiment of this application may be, for example, a low-pass filter, a highpass filter, a band-pass filter, a band-stop filter, or an active filter. The filter provided in this embodiment of this application is not limited to being used in the electronic device 1. The filter may also be used in fields such as sensing and detection. All filters in an electronic device in a related technology may be replaced with the filter provided in this embodiment of this application.

Certainly, the filter provided in this embodiment of this application is not limited to being integrated into the electronic device 1. Alternatively, the filter may be used as an independent component, or the filter may be integrated with a component like a power amplifier into a module (for example, a radio frequency device, a radio frequency front-end module, or a filter module).

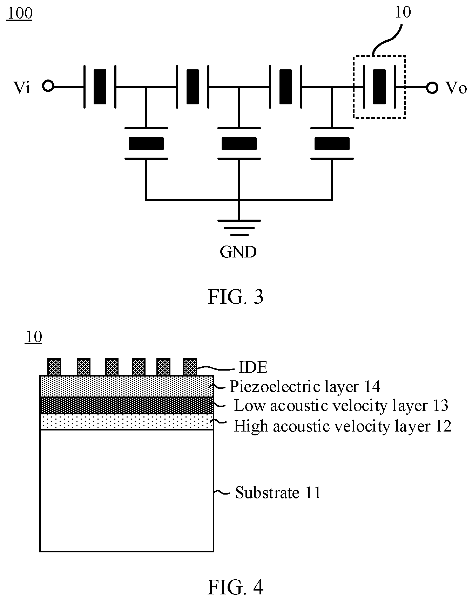

FIG. 3 is a schematic of a topology of a filter according to an embodiment of this application.

In some embodiments, as shown in FIG. 3, a filter 100 includes a plurality of surface acoustic wave (surface acoustic wave, SAW) resonators 10 that are cascaded. The plurality of surface acoustic wave resonators 10 may have different resonance frequencies, and may be cascaded together in a series-parallel manner. FIG. 3 further shows a signal input end Vi, a signal output end Vo, and a ground end GND that are of the filter 100.

Performance of the surface acoustic wave resonator 10 directly affects performance of the filter 100. The following describes a structure of the surface acoustic wave resonator 10 provided in this embodiment of this application.

FIG. 4 is a diagram of a structure of the surface acoustic wave resonator according to an embodiment of this application.

In some embodiments, as shown in FIG. 4, the surface acoustic wave resonator 10 includes a substrate 11, and a high acoustic velocity layer 12, a low acoustic velocity layer 13, a piezoelectric layer 14, and interdigital electrodes (interdigital electrodes, IDEs) that are sequentially disposed on the substrate 11.

According to the surface acoustic wave resonator 10 shown in FIG. 4, a surface acoustic wave resonator 10 with a high quality factor (quality factor, Q) value and high performance is obtained by using layered structures that are sequentially disposed. This structure is named an incredibly high performance (incredibly high performance, IHP) structure in the art.

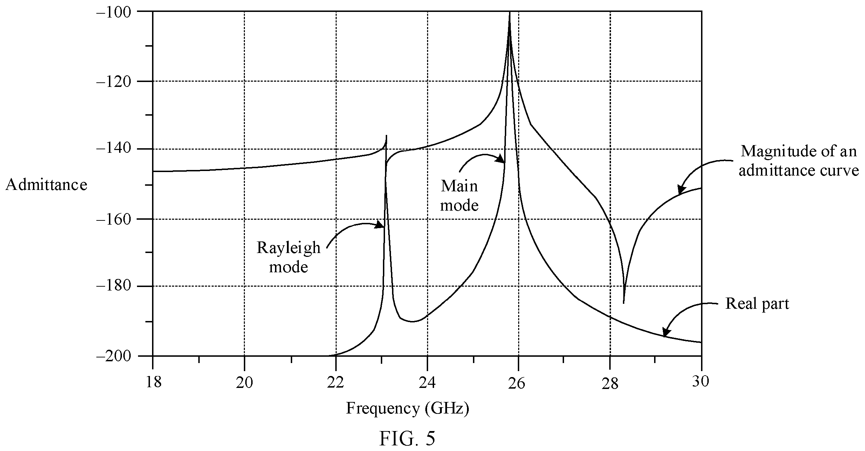

FIG. 5 is a diagram of an admittance curve of the surface acoustic wave resonator according to an embodiment of this application.

When a material of the piezoelectric layer 14 in the surface acoustic wave resonator 10 shown in FIG. 4 is a lithium niobate (LiNbO₃, LN) single crystal, the surface acoustic wave resonator 10 can provide a relatively large bandwidth. In FIG. 5, a horizontal coordinate is a frequency, a vertical coordinate is an admittance, and two curves respectively represent a magnitude and a real part of the admittance curve. As can be seen from the admittance curve obtained through simulation and shown in FIG. 5, a spurious mode (Rayleigh mode) exists on a low-frequency side of a main mode in the surface acoustic wave resonator. When the surface acoustic wave resonator 10 is used to form the filter 100, the Rayleigh mode deteriorates an insertion loss or out-of-band suppression of the filter 100.

An embodiment of this application further provides a surface acoustic wave resonator 10, configured to reduce intensity of a Rayleigh mode on a low-frequency side of a main mode.

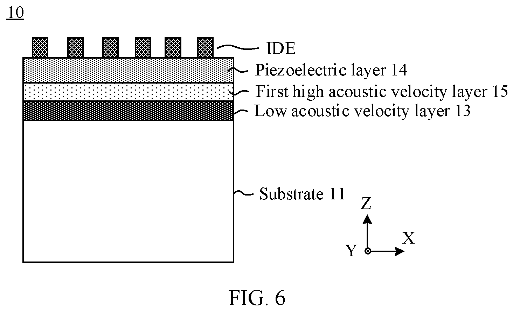

FIG. 6 is a diagram of a structure of a surface acoustic wave resonator according to an embodiment of this application.

An embodiment of this application provides a surface acoustic wave resonator 10. As shown in FIG. 6, the surface acoustic wave resonator 10 includes a substrate 11, and a low acoustic velocity layer 13, a first high acoustic velocity layer 15, a piezoelectric layer 14, and interdigital electrodes IDEs that are disposed on a side of the substrate 11.

The first high acoustic velocity layer 15 is disposed on a side of the low acoustic velocity layer 13 away from the substrate 11. For example, the first high acoustic velocity layer 15 is disposed on a surface of the low acoustic velocity layer 13 away from the substrate 11. The piezoelectric layer 14 is disposed on a side of the first high acoustic velocity layer 15 away from the substrate 11. For example, the piezoelectric layer 14 is disposed on a surface of the first high acoustic velocity layer 15 away from the substrate 11. The interdigital electrode IDE is disposed on a side of the piezoelectric layer 14 away from the substrate 11. For example, the interdigital electrode IDE is disposed on a surface of the piezoelectric layer 14 away from the substrate 11. In the surface acoustic wave resonator 10 provided in this embodiment of this application, the first high acoustic velocity layer 15 is disposed between the low acoustic velocity layer 13 and the piezoelectric layer 14.

A material of the substrate 11 may include, for example, glass (glass), silicon (Si), aluminum oxide (Al₂O₃), and silicon carbide (SiC). A thickness of the substrate 11 ranges, for example, from 100 µm to 1000 µm. For example, the thickness of the substrate 11 is 100 µm, 200 µm, 300 µm, 400 µm, 500 µm, 600 µm, 700 µm, 800 µm, 900 µm, or 1000 µm.

In this embodiment of this application, the first high acoustic velocity layer 15 is a film layer in which an acoustic velocity of a bulk wave in the first high acoustic velocity layer 15 is higher than that of a surface wave propagated in the piezoelectric layer 14. The low acoustic velocity layer 13 is a film layer in which an acoustic velocity of a bulk wave in the low acoustic velocity layer is lower than that of a surface wave propagated in the piezoelectric layer 14.

For example, a material of the piezoelectric layer 14 includes a LiNbO₃ single crystal. The low acoustic velocity layer 13 and the first high acoustic velocity layer 15 are made of an appropriate dielectric material that can achieve the high acoustic velocity and the low acoustic velocity determined above.

In some embodiments, when a material is selected for the low acoustic velocity layer 13, a shear horizontal surface acoustic wave velocity of the material of the piezoelectric layer 14 is greater than a shear horizontal bulk acoustic wave velocity of a material of the low acoustic velocity layer 13.

The shear horizontal bulk acoustic wave velocity is a propagation velocity, in an arrangement direction (a first direction X in FIG. 6) of the interdigital electrodes IDEs, of a surface wave whose vibration direction is in a shear direction (a second direction Y in FIG. 6). The shear horizontal bulk acoustic wave velocity is a propagation velocity, in an arrangement direction of interdigital electrodes, of a bulk acoustic wave whose vibration direction is in a shear direction. The shear direction is perpendicular to a thickness direction of the surface acoustic wave resonator 10 (a third direction Z in FIG. 6) and the arrangement direction of the interdigital electrodes IDEs.

For example, the material of the low acoustic velocity layer 13 includes at least one of silicon dioxide (SiO₂), a compound formed by adding fluorine (F), carbon (C), or boron (B) to SiO₂, silicon oxynitride (SiOₓN_{y}), and tantalum oxide (Ta₂O₅).

In some embodiments, when a material is selected for the first high acoustic velocity layer 15, a shear horizontal surface acoustic wave velocity of the material of the piezoelectric layer 14 is less than a shear horizontal bulk acoustic wave velocity of a material of the first high acoustic velocity layer 15.

For example, the material of the first high acoustic velocity layer 15 is at least one of silicon nitride (Si₃N₄), polycrystalline silicon, SiC, and silicon oxynitride.

Because the material of the piezoelectric layer in the surface acoustic wave resonator includes a lithium niobate single crystal, spurious modes such as a Rayleigh mode (Rayleigh mode) usually exist on a low-frequency side of a main mode. However, in this embodiment of this application, the first high acoustic velocity layer 15 is disposed between the low acoustic velocity layer 13 and the piezoelectric layer 14. Because a distribution depth of the Rayleigh mode in the thickness direction of the surface acoustic wave resonator 10 is greater than a distribution depth of the main mode in the thickness direction, the first high acoustic velocity layer 15 has a better acoustic velocity improvement effect on the Rayleigh mode than the main mode. In this way, a frequency spacing between the Rayleigh mode and the main mode can be reduced, so that the Rayleigh mode and the main mode are coupled, to achieve an effect of effectively suppressing intensity of the Rayleigh mode on the low-frequency side of the main mode in the surface acoustic wave resonator 10.

In some embodiments, a thickness *h*₁ of the first high acoustic velocity layer 15 ranges from 0.1λ to λ. For example, the thickness *h*₁ of the first high acoustic velocity layer 15 is 0.1λ, 0.2λ, 0.3λ, 0.4λ, 0.5λ, 0.6λ, 0.7λ, 0.8λ, 0.9λ, or λ.

Limiting the thickness *h*₁ of the first high acoustic velocity layer 15 to 0.1λ to λ can better suppress the spurious mode (Rayleigh mode) on the low-frequency side of the main mode. If the thickness *h*₁ of the first high acoustic velocity layer 15 is excessively small, the suppression on the Rayleigh mode may not be ideal even after the low acoustic velocity layer 13 and the first high acoustic velocity layer 15 are stacked.

In some embodiments, a thickness *h*₄ of the low acoustic velocity layer 13 ranges from 0.1λ to λ. For example, the thickness *h*₄ of the low acoustic velocity layer 13 is 0.1λ, 0.2λ, 0.3λ, 0.4λ, 0.5λ, 0.6λ, 0.7λ, 0.8λ, 0.9λ, or λ.

Limiting the thickness *h*₄ of the low acoustic velocity layer 13 to 0.1λ to λ can better suppress the spurious mode (Rayleigh mode) on the low-frequency side of the main mode. If the thickness of the low acoustic velocity layer is excessively small, the suppression on the Rayleigh mode may not be ideal even after the low acoustic velocity layer and the first high acoustic velocity layer are stacked.

In some embodiments, a thickness *h*₃ of the piezoelectric layer 14 ranges from 0.1λ to 0.5λ. For example, the thickness *h*₃ of the piezoelectric layer 14 is 0.1λ, 0.2λ, 0.3λ, 0.4λ, or 0.5λ.

Limiting the thickness *h*₃ of the piezoelectric layer 14 to 0.1λ to 0.5λ can better suppress the spurious mode (Rayleigh mode) on the low-frequency side of the main mode. In addition, the thickness of the piezoelectric layer 14 is directly related to a frequency of the surface acoustic wave resonator 10. A thinner piezoelectric layer 14 indicates a higher frequency of the surface acoustic wave resonator 10. In this application, the thickness of the piezoelectric layer 14 is limited to 0.1λ to 0.5λ, so that the surface acoustic wave resonator 10 can be applied to a high frequency, where the high frequency may be, for example, higher than 3.3 GHz.

In some embodiments, a thickness *h*₂ of the interdigital electrode IDE ranges from 0.05λ to 0.1λ. For example, the thickness *h*₂ of the interdigital electrode IDE is 0.05λ, 0.06λ, 0.07λ, 0.08λ, 0.09λ, or 0.1λ.

Limiting the thickness *h*₂ of the interdigital electrode IDE to 0.05λ to 0.1λ can better suppress the spurious mode (Rayleigh mode) on the low-frequency side of the main mode.

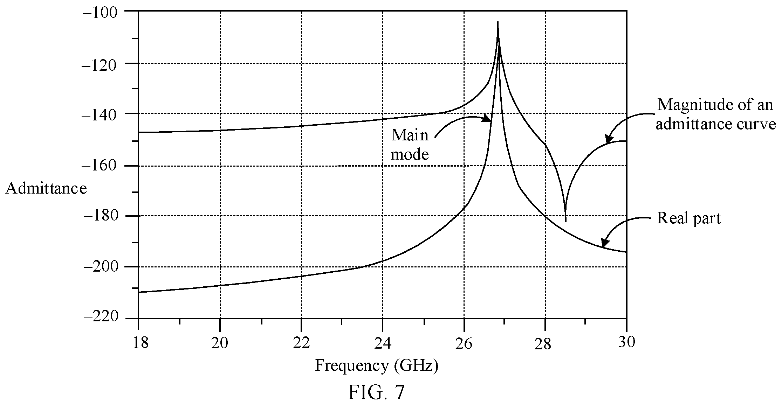

FIG. 7 is a diagram of an admittance curve of a surface acoustic wave resonator according to an embodiment of this application.

For example, a wavelength λ of a surface acoustic wave is set to 1200 µm. The thickness *h*₂ of the interdigital electrode IDE is 15.8%λ, and a material of the interdigital electrode IDE is aluminum (Al). The thickness *h*₃ of the piezoelectric layer 14 is 25%λ, and the material of the piezoelectric layer 14 is a LiNbO₃ single crystal. The thickness *h*₄ of the low acoustic velocity layer 13 is 60%λ, and the material of the low acoustic velocity layer 13 is silicon dioxide. The thickness *h*₁ of the first high acoustic velocity layer 15 is 8.3%λ, the material of the first high acoustic velocity layer 15 is silicon nitride, and a velocity *V* of a shear horizontal bulk acoustic wave of the first high acoustic velocity layer 15 is 5725 m/s. A thickness *h*₅ of the second high acoustic velocity layer 16 is 83%λ, and a material of the second high acoustic velocity layer 16 is polycrystalline silicon. The thickness of the substrate 11 is 100 µm, and the material of the substrate 11 is monocrystalline silicon. An admittance curve of the surface acoustic wave resonator 10 obtained through simulation is shown in FIG. 7. By comparing FIG. 7 with FIG. 5, it can be seen from the simulation results that the spurious mode (Rayleigh mode) on the low-frequency side of the main mode has been successfully suppressed.

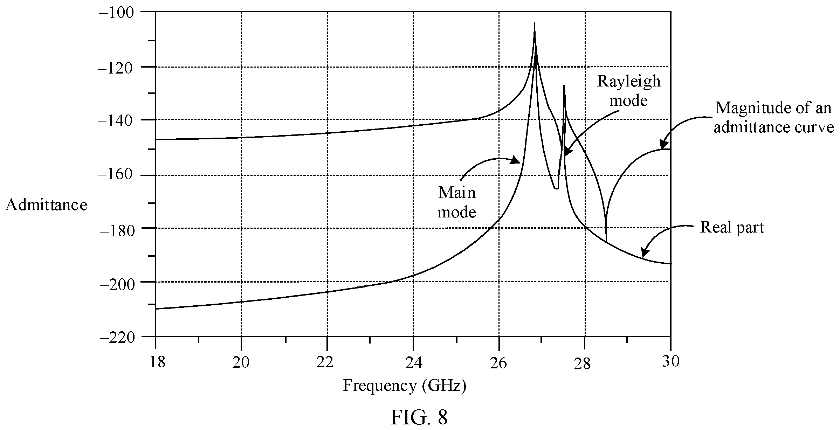

FIG. 8 is a diagram of an admittance curve of the surface acoustic wave resonator according to an embodiment of this application.

When the thickness *h*₁ of the first high acoustic velocity layer 15 is changed to 12.5%λ, and other parameters remain unchanged, an admittance curve of the surface acoustic wave resonator 10 obtained through simulation is shown in FIG. 8. A strong spurious mode (Rayleigh mode) is generated on a high-frequency side of a main mode in a real part.

In some embodiments, the thickness *h*₁ of the first high acoustic velocity layer 15 satisfies: $\left(1.38∗{10}^{- 4}∗V-0.318\right) ∗ \frac{{h}_{1}}{λ} - 1.7765 ∗ \frac{{h}_{2}}{λ} + 5.3 ∗ {10}^{- 2} ∗ \frac{{h}_{3}}{λ} + 6.83 ∗ {10}^{- 2} ∗ \frac{{h}_{4}}{λ} - 3.366 ∗ {10}^{- 7} ∗ {λ}^{2} + 1.178 ∗ λ + 0.2965 > 1 .$

Herein, *V* is the shear horizontal bulk acoustic wave velocity of the material of the first high acoustic velocity layer 15, *h*₂ is a thickness of the interdigital electrode IDE, *h*₃ is a thickness of the piezoelectric layer 14, and *h*₄ is a thickness of the low acoustic velocity layer 13.

In this embodiment of this application, the thickness may be understood as a size in a direction perpendicular to the substrate 11 or a size in a direction in which the low acoustic velocity layer 13 and the first high acoustic velocity layer 15 are stacked.

In the surface acoustic wave resonator 10 whose admittance curve is shown in FIG. 7, a thickness of each film layer satisfies the foregoing formula. It can be seen from FIG. 7 that the spurious mode (Rayleigh mode) on a low-frequency side of the main mode is almost completely suppressed, and performance of the surface acoustic wave resonator 10 is good.

In this embodiment of this application, the interdigital electrode IDE may be understood as a metal pattern that is formed on a surface of the piezoelectric layer 14 and that is in a shape of fingers of two hands crossing each other, and a function of the interdigital electrode IDE is to implement acoustic-to-electrical energy conversion.

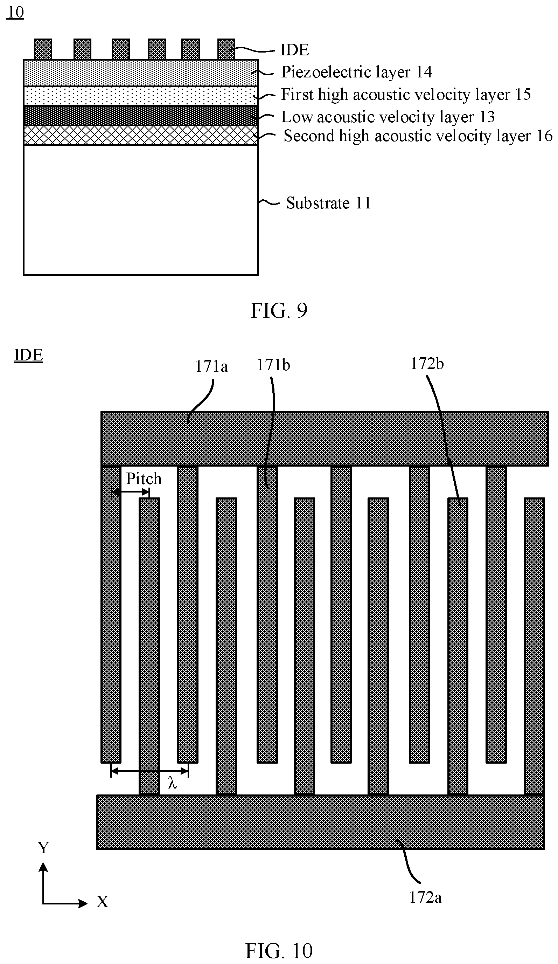

FIG. 9 is a diagram of a structure of the surface acoustic wave resonator according to an embodiment of this application.

In some embodiments, as shown in FIG. 9, the surface acoustic wave resonator 10 further includes a second high acoustic velocity layer 16. The second high acoustic velocity layer 16 is disposed on a side of the low acoustic velocity layer 13 close to the substrate 11. For example, the second high acoustic velocity layer 16 is disposed on a surface of the low acoustic velocity layer 13 close to the substrate 11.

In some embodiments, when a material is selected for the second high acoustic velocity layer 16, a shear horizontal bulk acoustic wave velocity of the material of the second high acoustic velocity layer 16 is greater than a shear horizontal bulk acoustic wave velocity of a material of the low acoustic velocity layer 13. For example, the material of the second high acoustic velocity layer 16 is at least one of silicon nitride (Si₃N₄), polycrystalline silicon, SiC, and silicon oxynitride.

The material of the first high acoustic velocity layer 15 may be the same as or different from the material of the second high acoustic velocity layer 16.

The second high acoustic velocity layer 16 is disposed on the side of the low acoustic velocity layer 13 close to the substrate 11, so that an acoustic wave can be prevented from leaking to the side of the second high acoustic velocity layer 16 close to the substrate 11. A surface acoustic wave is confined in space in which the piezoelectric layer 14 and the low acoustic velocity layer 13 are stacked, and is reused, so that a loss of a Q value is reduced.

In some embodiments, a thickness *h*₅ of the second high acoustic velocity layer 16 ranges from 0.1λ to λ. For example, the thickness *h*₅ of the second high acoustic velocity layer 16 is 0.1λ, 0.2λ, 0.3λ, 0.4λ, 0.5λ, 0.6λ, 0.7λ, 0.8λ, 0.9λ, or λ.

The thickness *h*₁ of the first high acoustic velocity layer 15 may be the same as or different from the thickness *h*₅ of the second high acoustic velocity layer 16. The thickness *h*₅ of the second high acoustic velocity layer 16 may be adjusted to adjust the Q value, so as to meet different requirements.

FIG. 10 is a top view of an interdigital electrode according to an embodiment of this application.

In an embodiment, as shown in FIG. 10, the interdigital electrode IDE includes a first busbar (busbar) 171a and a second busbar 172a that are disposed opposite to each other, a plurality of first electrode fingers 171b, and a plurality of second electrode fingers 172b. Extension directions of the first busbar 171a and the second busbar 172a are parallel to a first direction X, and an extension direction of the first electrode finger 171b is parallel to a second direction Y. The first electrode finger 171b protrudes from the first busbar 171a to the second busbar 172a. The plurality of first electrode fingers 171b are sequentially arranged in the extension direction (the first direction X) of the first busbar 171a, and the plurality of first electrode fingers 171b are coupled to the first busbar 171a. An extension direction of the second electrode finger 172b is parallel to the second direction Y. The second electrode finger 172b protrudes from the second busbar 172a to the first busbar 171a. The plurality of second electrode fingers 172b are sequentially arranged in the extension direction (the first direction X) of the second busbar 172a, and the plurality of second electrode fingers 172b are coupled to the second busbar 172a. The first direction X intersects with the second direction Y. Parallelism in this embodiment of this application includes approximate parallelism, and deviations within a range of process errors (for example, ±5°) all belong to the parallelism in embodiments of this application.

The plurality of first electrode fingers 171b and the plurality of second electrode fingers 172b are sequentially alternately arranged between the first busbar 171a and the second busbar 172a in the first direction X, and the first electrode finger 171b and the second electrode finger 172b are not in contact with each other.

The foregoing "the plurality of first electrode fingers 171b and the plurality of second electrode fingers 172b are sequentially alternately arranged between the first busbar 171a and the second busbar 172a in the first direction X" means that between the first busbar 171a and the second busbar 172a, one second electrode finger 172b is disposed between every two first electrode fingers 171b, and one first electrode finger 171b is disposed between every two second electrode fingers 172b.

A quantity of first electrode fingers 171b and a quantity of second electrode fingers 172b in the interdigital electrode IDE are not limited, and may be set according to a requirement. The plurality of first electrode fingers 171b may be arranged at an equal pitch, or may be arranged at a non-equal pitch. Similarly, the plurality of second electrode fingers 172b may be arranged at an equal pitch, or may be arranged at a non-equal pitch. The first electrode finger 171b is used as an example. That the plurality of first electrode fingers 171b are arranged at a non-equal pitch means that a pitch between at least one pair of adjacent first electrode fingers 171b is different from a pitch between another pair of adjacent first electrode fingers 171b.

In addition, that the plurality of first electrode fingers 171b and the plurality of second electrode fingers 172b are sequentially alternately arranged may indicate that a pitch between the first electrode fingers 171b and the second electrode fingers 172b that are adjacent to each other is the same; or may indicate that pitches between a plurality of pairs of first electrode fingers 171b and second electrode fingers 172b that are adjacent are not completely the same, that is, a pitch between at least one pair of first electrode finger 171b and second electrode finger 172b that are adjacent to each other is different from a pitch between another pair of first electrode finger 171b and second electrode finger 172b that are adjacent to each other.

It may be understood that, the pitch (pitch) between the first electrode finger 171b and the second electrode finger 172b, and finger widths of the first electrode finger 171b and the second electrode finger 172b are mainly affected by photolithography and development processes. A resonance frequency and a bandwidth of the surface acoustic wave resonator 10 may be changed by adjusting the pitch between the first electrode finger 171b and the second electrode finger 172b, and the finger widths of the first electrode finger 171b and the second electrode finger 172b. Therefore, an electronic signal of a specific frequency may pass through the surface acoustic wave resonator 10, and an electronic signal of another frequency may be filtered out by the surface acoustic wave resonator 10.

The pitch between the first electrode finger 171b and the second electrode finger 172b may be a distance from a center of the first electrode finger 171b to a center of the second electrode finger 172b.

In some embodiments, the material of the first electrode finger 171b and the second electrode finger 172b may include one or more of aluminum (Al), copper (Cu), platinum (Pt), gold (Au), nickel (Ni), titanium (Ti), Ag (silver), chromium (Cr), molybdenum (Mo), tungsten (W), tantalum (Ta), and the like.

In some embodiments, λ=2*pitch. A wavelength λ of a surface acoustic wave may be determined based on the pitch between the first electrode finger 171b and the second electrode finger 172b, so as to determine a thickness of each film layer in the surface acoustic wave resonator 10.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A surface acoustic wave resonator, comprising:
a substrate;
a low acoustic velocity layer, disposed on a side of the substrate;
a first high acoustic velocity layer, disposed on a side of the low acoustic velocity layer away from the substrate;
a piezoelectric layer, disposed on a side of the first high acoustic velocity layer away from the substrate, wherein a material of the piezoelectric layer comprises a lithium niobate single crystal; and
interdigital electrodes, disposed on a side of the piezoelectric layer away from the substrate, wherein
a shear horizontal surface acoustic wave velocity of the material of the piezoelectric layer is greater than a shear horizontal bulk acoustic wave velocity of a material of the low acoustic velocity layer and is less than a shear horizontal bulk acoustic wave velocity of a material of the first high acoustic velocity layer.

2. The surface acoustic wave resonator according to claim 1, wherein a thickness *h*₁ of the first high acoustic velocity layer ranges from 0.1λ to λ, and λ is a wavelength of the surface acoustic wave.

3. The surface acoustic wave resonator according to claim 2, wherein the thickness *h*₁ of the first high acoustic velocity layer satisfies: $\left(1.38∗{10}^{- 4}∗V-0.318\right) ∗ \frac{{h}_{1}}{λ} - 1.7765 ∗ \frac{{h}_{2}}{λ} + 5.3 ∗ {10}^{- 2} ∗ \frac{{h}_{3}}{λ} + 6.83 ∗ {10}^{- 2} ∗ \frac{{h}_{4}}{λ} - 3.366 ∗ {10}^{- 7} ∗ {λ}^{2} + 1.178 ∗ λ + 0.2965 > 1 ,$ wherein *V* is the shear horizontal bulk acoustic wave velocity of the material of the first high acoustic velocity layer, *h*₂ is a thickness of the interdigital electrode, *h*₃ is a thickness of the piezoelectric layer, and *h*₄ is a thickness of the low acoustic velocity layer.

4. The surface acoustic wave resonator according to any one of claims 1 to 3, wherein the surface acoustic wave resonator further comprises a second high acoustic velocity layer, the second high acoustic velocity layer is disposed on a side of the low acoustic velocity layer close to the substrate, and a shear horizontal bulk acoustic wave velocity of a material of the second high acoustic velocity layer is greater than the shear horizontal bulk acoustic wave velocity of the material of the low acoustic velocity layer.

5. The surface acoustic wave resonator according to any one of claims 1 to 4, wherein the material of the first high acoustic velocity layer comprises at least one of silicon nitride, polycrystalline silicon, silicon carbide, and silicon oxynitride.

6. The surface acoustic wave resonator according to any one of claims 1 to 5, wherein the thickness *h*₄ of the low acoustic velocity layer ranges from 0.1λ to λ, and λ is the wavelength of the surface acoustic wave.

7. The surface acoustic wave resonator according to any one of claims 1 to 6, wherein the thickness *h*₃ of the piezoelectric layer ranges from 0.1λ to 0.5λ, and λ is the wavelength of the surface acoustic wave.

8. The surface acoustic wave resonator according to any one of claims 1 to 7, wherein the thickness *h*₂ of the interdigital electrode ranges from 0.05λ to 0.1λ, and λ is the wavelength of the surface acoustic wave.

9. The surface acoustic wave resonator according to claim 4, wherein a thickness *h*₅ of the second high acoustic velocity layer ranges from 0.1λ to λ, and λ is the wavelength of the surface acoustic wave.

10. A filter, comprising a plurality of surface acoustic wave resonators that are cascaded, wherein the surface acoustic wave resonators comprises the surface acoustic wave resonator according to any one of claims 1 to 9.

11. A radio frequency front-end module, comprising a filter and an amplifier, wherein the filter is coupled to the amplifier, and the filter comprises the filter according to claim 10.

12. An electronic device, comprising a filter and a circuit board, wherein the filter is disposed on the circuit board, and the filter comprises the filter according to claim 10.
